# EUROPEAN PATENT SPECIFICATION

(11) **EP 3 706 435 B1**
(45) Date of publication and mention of the grant of the patent: **04.05.2022**
(21) Application number: 18871962.9
(22) Date of filing: 28.09.2018
(51) Int. Cl.: G01H 11/08, H04R 17/00, H01L 41/053

(54) **ULTRASONIC SENSOR**
ULTRASCHALLSENSOR
CAPTEUR À ULTRASONS

(30) Priority: 02.11.2017 JP 2017212681
(43) Date of publication of application: 09.09.2020
(73) Proprietor: Murata Manufacturing Co., Ltd., Nagaokakyo-shi, Kyoto 617-8555 (JP)
(72) Inventor: HATAKEYAMA, Hirotoshi, Nagaokakyo-shi, Kyoto 617-8555 (JP)
(74) Representative: Reeve, Nicholas Edward
(86) International application number: PCT/JP2018/036272
(87) International publication number: WO 2019/087634

(56) References cited:
- JP-A- 2002 112 395
- JP-A- 2002 228 742
- JP-A- 2002 228 742
- JP-A- 2010 050 963
- JP-A- 2010 050 963
- JP-A- 2014 110 459
- JP-A- 2014 204 387
- JP-A- 2014 230 109

## Description

### Technical Field

The present invention relates to an ultrasonic sensor.

### Background Art

An ultrasonic sensor including a casing formed in a cylindrical shape with a closed bottom is disclosed in Japanese Unexamined Patent Application Publication No. H11-266497. The casing is formed as a combination of a cylindrical section and a planar vibrator that are bonded to each other by an adhesive material. In JP H11-266497, an insulating material, such as engineering plastics, is used for the cylindrical section, while a conductive member, such as aluminum, is used for the vibrator. An ultrasonic sensor having a similar structure is disclosed in Japanese Unexamined Patent Application Publication No. 2000-23295.

It is desirable that an ultrasonic sensor be able to increase the sound pressure to be higher and the frequency bandwidth to be wider without reducing the resonant frequency. When a vibrator vibrates, a stress is likely to concentrate at the geometric discontinuities between the inner surface of a planar section, which corresponds to a vibrator, and the inner peripheral surface of a cylindrical section. If the planar vibrator made of a metal and the cylindrical section made of a resin are bonded by adhesive, the above-described geometric discontinuities coincide with the bonding joint portion between the metal and the resin. In this manner, if the bonding joint portion is located at the same position as the geometric discontinuities, over the repeated use of the ultrasonic sensor, a breakage may occur in the bonding joint portion due to the stress concentration.

JP2002-228742 discloses a bottom case part formed of a plastic case part provided with an adjustable layer, and a metal case part to be bonded to the bottom case part for sealing and forming a piezoelectric element housing space together with the bottom case part. A piezoelectric element provided with electrodes in an upper and a lower surfaces thereof is fitted to the inner bottom surface of the bottom case part and external shield wires to be electrically connected to both electrodes of the piezoelectric element are taken out of a side surface of the metal case part. An open end of the metal case part is filled with a sealing material.

JP2010-050963 discloses an ultrasonic sensor case, which utilizes a piezoelectric element, and which includes: a plate-like vibrating part, where the piezoelectric element is provided; and a sidewall part provided so as to surround an area, where the piezoelectric element of the vibrating part is provided, and having an opening at a position facing the vibrating part. The vibrating part is composed of a thermoplastic resin containing fiber-like fillers and the thermoplastic resin is a polyphenylene-sulfide resin, polyether-ether-ketone resin, polyethersulfone resin, polybutylene terephthalate resin, or resin obtained by blending two or more of them. We have appreciated that it would be desirable to provide an ultrasonic sensor which is able to increase the sound pressure to be higher and the frequency bandwidth to be wider without reducing the resonant frequency and also to reduce the occurrence of a breakage caused by the stress concentration at the geometric discontinuities.

### SUMMARY OF THE INVENTION

An ultrasonic sensor according to the present invention includes a casing and a piezoelectric vibrator element. The casing includes first and second units. The first unit is made of a metal. The second unit is made of a resin. The first unit is formed in a cylindrical shape extending in a first direction. The second unit is connected to one end of the first unit in the first direction and includes a cylindrical section and a bottom plate. The cylindrical section extends in the first direction. The bottom plate is a disk-like portion which closes an end of the cylindrical section positioned farther away from the first unit in the first direction. The piezoelectric vibrator element is mounted on the bottom plate. The bottom plate includes a bottom-plate first layer and a bottom-plate second layer. The bottom-plate first layer is made of carbon fiber reinforced plastic CFRP and is positioned at a side of the bottom plate closer to the first unit in the first direction. The bottom-plate second layer is made of a resin different from CFRP and is positioned at a side of the bottom plate farther away from the first unit in the first direction.

According to the present invention, it is possible to implement an ultrasonic sensor which is able to increase the sound pressure to be higher and the frequency bandwidth to be wider without reducing the resonant frequency and also to reduce the occurrence of a breakage caused by the stress concentration at the geometric discontinuities.

### BRIEF DESCRIPTION OF THE DRAWINGS

Fig. 1 is a side view of an ultrasonic sensor according to a first example .
Fig. 2 is a plan view of the ultrasonic sensor according to the first example.
Fig. 3 is a sectional view of the ultrasonic sensor according to the first example.
Fig. 4 is a perspective view only illustrating a casing removed from the ultrasonic sensor according to the first example.
Fig. 5 is a sectional view only illustrating the casing and a piezoelectric vibrator element of the ultrasonic sensor according to the first example.
Fig. 6 is a side view of an ultrasonic sensor according to a second example.
Fig. 7 is a sectional view only illustrating a casing and a piezoelectric vibrator element of the ultrasonic sensor according to the second example.
Fig. 8 is a side view of an ultrasonic sensor according to a third example.
Fig. 9 is a sectional view only illustrating a casing and a piezoelectric vibrator element of the ultrasonic sensor according to the third example.
Fig. 10 is a perspective view illustrating the ultrasonic sensor according to the third example shown in Fig. 8 to make the bottom surface viewable.
Fig. 11 is a side view of an ultrasonic sensor according to a first embodiment of the present invention.
Fig. 12 is a sectional view only illustrating a casing and a piezoelectric vibrator element of the ultrasonic sensor according to the first embodiment of the present invention.
Fig. 13 illustrates a 1/4 model used in the simulations.
Fig. 14 is a first graph illustrating the simulation results.
Fig. 15 is a second graph illustrating the simulation results.
Fig. 16 is a third graph illustrating the simulation results.
Fig. 17 is a plan view illustrating a first example of the shape of a hollow portion provided in the casing.
Fig. 18 is a plan view illustrating a second example of the shape of a hollow portion provided in the casing.
Fig. 19 is a plan view illustrating a third example of the shape of a hollow portion provided in the casing.

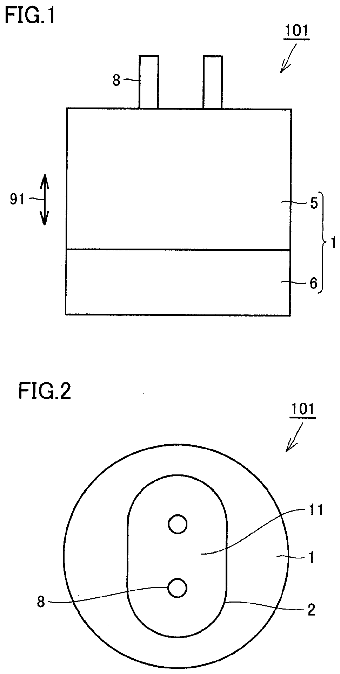

The first example, the second example and the third example in Fig.1-10 are not according to the invention and are present for illustration purposes only.

### DESCRIPTION OF EMBODIMENTS

The dimension ratios among the elements in the drawings do not necessarily represent the actual ratios, and may be shown in an exaggerating manner for the sake of representation. In the following description, while referring to the positional concept of "top" or "bottom" ("on" or "under"), it does not necessarily mean the absolute position of "top" or "bottom" ("on" or "under"), and may mean the relative position of "top" or "bottom" ("on" or "under") in the orientations of the elements in the drawings.

### First Example

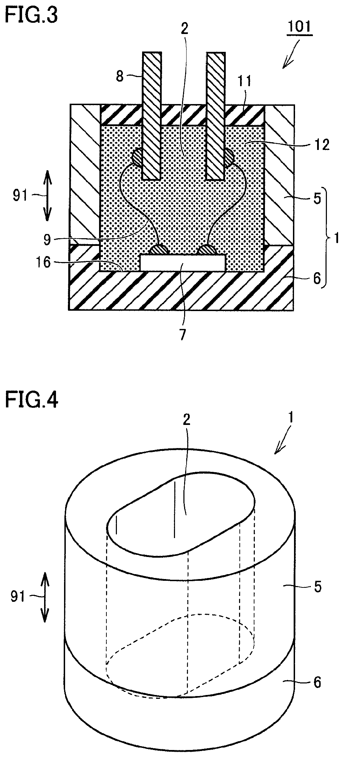

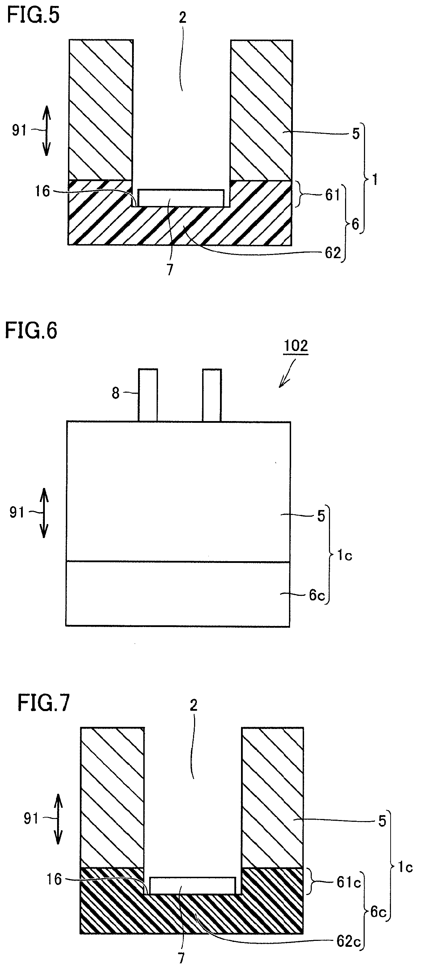

An ultrasonic sensor according to a first example not forming an embodiment of the invention will be described below with reference to Figs. 1 through 5. A side view of an ultrasonic sensor 101 according to this example is shown in Fig. 1. A plan view of the ultrasonic sensor 101 is shown in Fig. 2. The ultrasonic sensor 101 includes a casing 1 formed in a cylindrical shape with a closed bottom and two terminals 8 protruding from the casing 1. A sectional view of the ultrasonic sensor 101 is shown in Fig. 3. The ultrasonic sensor 101 includes a piezoelectric vibrator element 7. The casing 1 has a hollow portion 2. The casing 1 includes a first unit 5 and a second unit 6. The first unit 5 and the second unit 6 are bonded to each other. The mere casing 1 removed from the ultrasonic sensor 101 is shown in Fig. 4. A sectional view only illustrating the casing 1 and the piezoelectric vibrator element 7 is shown in Fig. 5.

The first unit 5 is made of a metal and is formed in a cylindrical shape extending in a first direction 91. The second unit 6 is made of a resin and is connected to one end of the first unit 5 in the first direction 91. The second unit 6 is preferably made of a resin which excels in heat resistance and chemical resistance and which also has a high mechanical strength, such as polyethersulfone, polyphenylene sulfide, and polynonamethylene terephthalamide. In this manner, the casing 1 includes the first unit 5 and the second unit 6 which are made of different materials. The second unit 6 includes a cylindrical section 61 and a bottom plate 62. The cylindrical section 61 is connected to one end of the first unit 5 in the first direction 91 and is formed in a cylindrical shape extending in the first direction 91. The bottom plate 62 is a disk-like portion which closes the end of the cylindrical section 61 positioned farther away from the first unit 5 in the first direction 91. The piezoelectric vibrator element 7 is mounted on the second unit 6, and more specifically, on a surface 16 of the bottom plate 62 positioned closer to the first unit 5.

As shown in Fig. 3, the piezoelectric vibrator element 7 and each of the terminals 8 are electrically connected to each other via wiring 9. A filler 12 fills the inside of the hollow portion 2. The piezoelectric vibrator element 7 and the wiring 9 are sealed by the filler 12. A lid 11 is disposed to cover the entrance of the hollow portion 2. The filler 12 is covered by the lid 11. The configuration with the lid 11 is only an example. The provision of the lid 11 may be omitted.

In the ultrasonic sensor 101, the geometric discontinuities in the casing 1 are located at a position corresponding to the second unit 6. That is, the geometric discontinuities in the casing 1 are located at a position different from the joint portion where the first and second units 5 and 6 are bonded to each other. This makes it unlikely to cause a breakage at the joint portion due to the stress concentration at the geometric discontinuities even if the ultrasonic sensor 101 is repeatedly used. According to this embodiment, it is thus possible to implement an ultrasonic sensor which is able to increase the sound pressure to be higher and the frequency bandwidth to be wider without reducing the resonant frequency and also to reduce the occurrence of a breakage caused by the stress concentration at the geometric discontinuities. The simulation results validating the advantages will be discussed later.

In the ultrasonic sensor according to this example, the stress applied to the bonding surface between different materials forming the two units of the casing can be decreased. The ultrasonic sensor can thus reduce the occurrence of failures caused by the stress applied to the bonding surface.

The metal forming the first unit 5 may be aluminum, for example. Aluminum may also be used in the examples described below.

In this example, the terminals 8 are formed in a tubular shape. However, this is only an example, and terminals may be formed in another shape. The terminals may not necessarily stand straight. The terminals may be a metal film extending along the surface of the first unit 5. The terminals may be flexible wiring. These modifications of the terminals may also be made in the examples described below.

### Second Example

An ultrasonic sensor according to a second example not forming an embodiment of the invention will be described below with reference to Figs. 6 and 7. A side view of an ultrasonic sensor 102 according to this example is shown in Fig. 6. The ultrasonic sensor 102 includes a casing 1c formed in a cylindrical shape with a closed bottom and two terminals 8 protruding from the casing 1c. A sectional view only illustrating the casing 1c and a piezoelectric vibrator element 7 is shown in Fig. 7. The ultrasonic sensor 102 includes the piezoelectric vibrator element 7. The casing 1c has a hollow portion 2. The casing 1c includes a first unit 5 and a second unit 6c. The first unit 5 and the second unit 6c are bonded to each other.

The first unit 5 is made of a metal, such as aluminum, and is formed in a cylindrical shape extending in a first direction 91. The second unit 6c is made of CFRP (carbon fiber reinforced plastic) and is connected to one end of the first unit 5 in the first direction 91. The second unit 6c includes a cylindrical section 61c and a bottom plate 62c. The cylindrical section 61c is connected to one end of the first unit 5 in the first direction 91 and is formed in a cylindrical shape extending in the first direction 91. The bottom plate 62c is a disk-like portion which closes the end of the cylindrical section 61c positioned farther away from the first unit 5 in the first direction 91. The piezoelectric vibrator element 7 is mounted on the second unit 6c, and more specifically, on a surface 16 of the bottom plate 62c positioned closer to the first unit 5. The second unit 6c is integrally formed by the CFRP. The matrix forming the CFRP is preferably a resin which excels in heat resistance and chemical resistance and which also has a high mechanical strength, such as polyethersulfone, polyphenylene sulfide, and polynonamethylene terephthalamide. The carbon fiber in the CFRP may be either one of continuous fiber and discontinuous fiber. The CFRP used in the second unit 6c including the bottom plate 62c preferably has a high elastic modulus. In this example, the second unit 6c is made of CFRP having an elastic modulus of 20 Gpa or higher. In this manner, the casing 1c includes the first unit 5 and the second unit 6c which are made of different materials.

The configurations of the other elements are similar to those of the first example.

In this example, too, advantages similar to those of the first example can be obtained. To maintain the resonant frequency, a material having a high elastic modulus is preferably used for a portion which is displaced by a considerable amount by vibration. In this example, the bottom plate 62c of the second unit 6c, which is a portion displaced by a considerable amount by vibration, is advantageously made of CFRP, which is a material having a high elastic modulus.

### Third Example

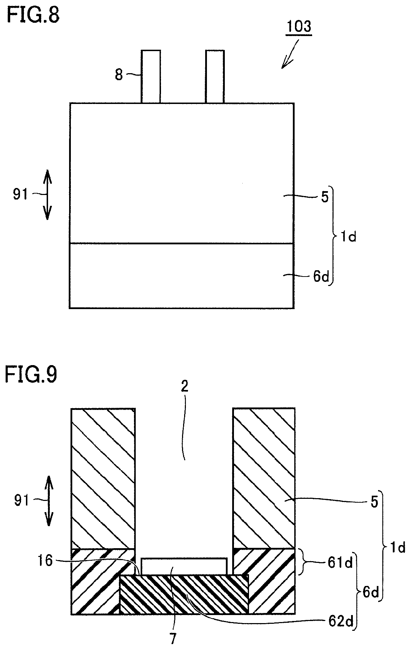

An ultrasonic sensor according to a third example not forming an embodiment of the invention will be described below with reference to Figs. 8 through 10. A side view of an ultrasonic sensor 103 according to this example is shown in Fig. 8. The ultrasonic sensor 103 includes a casing 1d formed in a cylindrical shape with a closed bottom and two terminals 8 protruding from the casing 1d. A sectional view only illustrating the casing 1d and a piezoelectric vibrator element 7 is shown in Fig. 9. The ultrasonic sensor 103 includes the piezoelectric vibrator element 7. The casing 1d has a hollow portion 2. The casing 1d includes a first unit 5 and a second unit 6d. The first unit 5 and the second unit 6d are bonded to each other.

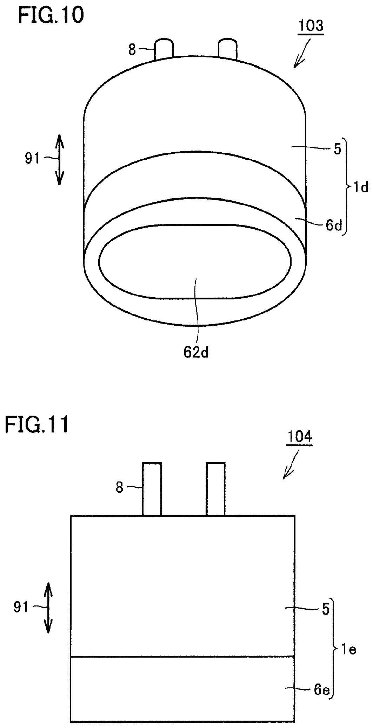

The first unit 5 is made of a metal, such as aluminum, and is formed in a cylindrical shape extending in a first direction 91. The second unit 6d is connected to one end of the first unit 5 in the first direction 91. The second unit 6d includes a cylindrical section 61d and a bottom plate 62d. The cylindrical section 61d is connected to one end of the first unit 5 in the first direction 91 and is formed in a cylindrical shape extending in the first direction 91. The bottom plate 62d is a disk-like portion which closes the end of the cylindrical section 61d positioned farther away from the first unit 5 in the first direction 91. The bottom plate 62d is made of CFRP and a resin different from CFRP. More specifically, a portion of the bottom plate 62d on which the piezoelectric vibrator element 7 is mounted is made of CFRP, while the other portion of the bottom plate 62d is made of a resin different from CFRP. The cylindrical section 61d is made of a resin different from CFRP. The matrix forming the CFRP is preferably a resin which excels in heat resistance and chemical resistance and which also has a high mechanical strength, such as polyethersulfone, polyphenylene sulfide, and polynonamethylene terephthalamide. The carbon fiber in the CFRP may be either one of continuous fiber and discontinuous fiber. The CFRP used in the portion of the bottom plate 62d on which the piezoelectric vibrator element 7 is mounted preferably has a high elastic modulus. In this example, the portion of the bottom plate 62d on which the piezoelectric vibrator element 7 is mounted is made of CFRP having an elastic modulus of 20 Gpa or higher. "A resin different from CFRP" forming part of the bottom plate 62d and the cylindrical section 61d is preferably a resin which excels in heat resistance and chemical resistance and which also has a high mechanical strength, such as polyethersulfone, polyphenylene sulfide, and polynonamethylene terephthalamide. In this manner, the casing 1d includes the first unit 5 and the second unit 6d which are made of different materials. The piezoelectric vibrator element 7 is mounted on the second unit 6d, and more specifically, on a surface 16 of the bottom plate 62d positioned closer to the first unit 5. A perspective view illustrating the ultrasonic sensor 103 in Fig. 8 to make the bottom surface, that is, the surface used for sending and receiving ultrasonic waves, viewable, is shown in Fig. 10. In Fig. 10, the boundary between the portion of the second unit 6d made of a resin and the other portion made of CFRP can be seen.

The configurations of the other elements are similar to those of the first example.

In this example, too, advantages similar to those of the first example can be obtained. To maintain the resonant frequency, a material having a high elastic modulus is preferably used for a portion to be subjected to a high stress by vibration. In this example, "the portion of the bottom plate 62d of the second unit 6d on which the piezoelectric vibrator element 7 is mounted", which is a portion displaced by a considerable amount by vibration, is advantageously made of CFRP, which is a material having a high elastic modulus. CFRP is relatively an expensive material, while a resin is less expensive. In this example, to form the second unit 6d, CFRP is used only for part of the bottom plate 62d, thereby making it possible to reduce the cost.

The bottom plate 62d and the portion including the cylindrical section 61d are preferably welded to each other. The portion including the cylindrical section 61d is a portion made of a resin. The portion of the bottom plate 62d is made of CFRP, which also contains resin components. "The portion including the cylindrical section 61d" is a portion of the bottom plate 62d other than the portion of the bottom plate 62d on which the piezoelectric vibrator element 7 is mounted. If the portion including the cylindrical section 61d and the bottom plate 62d are welded to each other, they can be firmly bonded to each other, thereby improving the reliability of the casing 1d. This further leads to enhancing the reliability of the ultrasonic sensor 103.

### First Embodiment

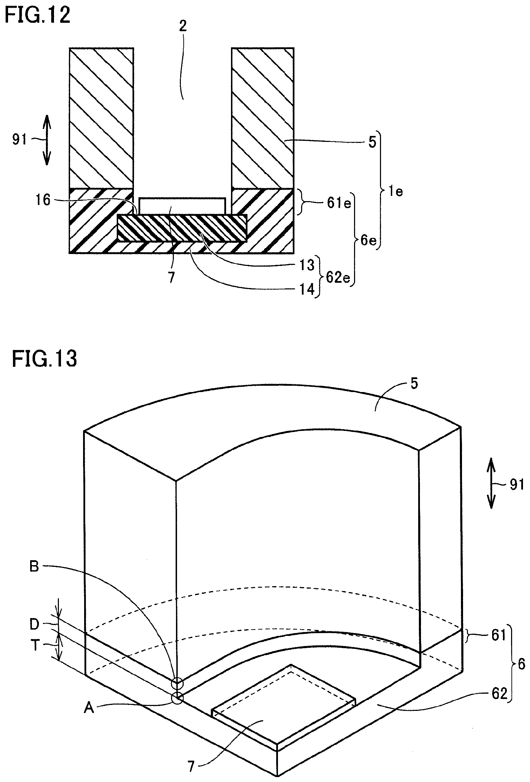

An ultrasonic sensor according to a first embodiment of the present invention will be described below with reference to Figs. 11 and 12. A side view of an ultrasonic sensor 104 according to this embodiment is shown in Fig. 11. The ultrasonic sensor 104 includes a casing 1e formed in a cylindrical shape with a closed bottom and two terminals 8 protruding from the casing 1e. A sectional view only illustrating the casing 1e and a piezoelectric vibrator element 7 is shown in Fig. 12. The ultrasonic sensor 104 includes the piezoelectric vibrator element 7. The casing 1e has a hollow portion 2. The casing 1e includes a first unit 5 and a second unit 6e. The first unit 5 and the second unit 6e are bonded to each other.

The first unit 5 is made of a metal, such as aluminum, and is formed in a cylindrical shape extending in a first direction 91. The second unit 6e is connected to one end of the first unit 5 in the first direction 91. The second unit 6e includes a cylindrical section 61e and a bottom plate 62e. The cylindrical section 61e is connected to one end of the first unit 5 in the first direction 91 and is formed in a cylindrical shape extending in the first direction 91. The bottom plate 62e is a disk-like portion which closes the end of the cylindrical section 61e positioned farther away from the first unit 5 in the first direction 91. The piezoelectric vibrator element 7 is mounted on the second unit 6e, and more specifically, on a surface 16 of the bottom plate 62e positioned closer to the first unit 5. The bottom plate 62e includes a bottom-plate first layer 13 and a bottom-plate second layer 14. The bottom-plate first layer 13 is positioned at the side of the bottom plate 62e closer to the first unit 5 in the first direction 91. The bottom-plate first layer 13 is made of CFRP. The bottom-plate second layer 14 is positioned at the side of the bottom plate 62e farther away from the first unit 5 in the first direction 91 and is superposed on the bottom-plate first layer 13. The bottom-plate second layer 14 is made of a resin different from CFRP. In this manner, the bottom plate 62e is made of CFRP and a resin different from CFRP. More specifically, the bottom-plate first layer 13 of the bottom plate 62e on which the piezoelectric vibrator element 7 is mounted is made of CFRP, while the bottom-plate second layer 14 of the bottom plate 62e is made of a resin different from CFRP. The cylindrical section 61e is made of the same resin as the bottom-plate second layer 14. The matrix forming the CFRP is preferably a resin which excels in heat resistance and chemical resistance and which also has a high mechanical strength, such as polyethersulfone, polyphenylene sulfide, and polynonamethylene terephthalamide. The carbon fiber in the CFRP may be either one of continuous fiber and discontinuous fiber. The CFRP used in the bottom-plate first layer 13 preferably has a high elastic modulus. In this embodiment, the bottom-plate first layer 13 is made of CFRP having an elastic modulus of 20 Gpa or higher. "A resin different from CFRP" forming the bottom-plate second layer 14 and the cylindrical section 61e is preferably a resin which excels in heat resistance and chemical resistance and which also has a high mechanical strength, such as polyethersulfone, polyphenylene sulfide, and polynonamethylene terephthalamide. In this manner, the casing 1e includes the first unit 5 and the second unit 6e which are made of different materials.

The configurations of the other elements are similar to those of the first example.

In this embodiment, too, advantages similar to those of the first example can be obtained. In this embodiment, the outer surfaces of the casing 1e are made of a resin different from CFRP and thus present a highly aesthetic appearance. The surface of the ultrasonic sensor 104 used for sending and receiving ultrasonic waves is only made of a resin different from CFRP, which makes it easy to paint.

As is discussed in this embodiment, it is preferable that the bottom-plate second layer 14 and the cylindrical section 61e be formed integrally. This does not necessarily mean that the bottom-plate second layer 14 and the cylindrical section 61e directly contact each other. Another element may be interposed between the bottom-plate second layer 14 and the cylindrical section 61e. Integrally forming the bottom-plate second layer 14 and the cylindrical section 61e can make the surface used for sending and receiving ultrasonic waves free from joint portions between different elements, thereby maintaining a highly aesthetic appearance.

### Simulations

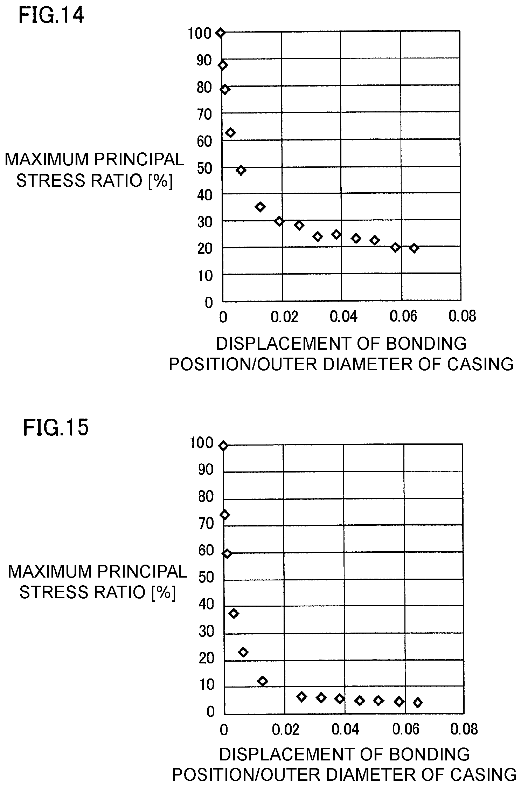

As shown in Fig. 13, a 1/4 portion of a combination of a casing and the piezoelectric vibrator element 7 is extracted and is assumed as a model. For the sake of description, the ultrasonic sensor 101 of the first example will be discussed by way of example while referring to the reference numerals used in the first example. The first unit 5 is made of aluminum. The outer diameter of the casing 1 is 15.5 mm. The thickness T of the bottom plate 62 is 1.0 mm. When the bottom plate 62 vibrates in response to the sending or receiving of ultrasonic waves, a stress is applied mainly to a pointA. The maximum principal stress at a point B, which is the innermost point at the interface between the first unit 5 and the second unit 6, is found by simulations. The displacement amount of the point B from the pointA is indicated by D. The simulation results obtained by using this model are shown in Figs. 14 through 16. Fig. 14 illustrates the simulation results concerning the ultrasonic sensor 101. "Displacement of bonding position" on the horizontal axis represents the displacement amount D. "Outer diameter of casing" represents the outer diameter of the casing 1. In Fig. 14, the maximum principal stress is assumed as 100% when D=0, and the maximum principal stress ratio, that is, the maximum principal stress represented by percentage, is taken on the vertical axis. As shown in Fig. 14, increasing the displacement D of the bonding position can reduce the maximum principal stress ratio at the point B.

Regarding the ultrasonic sensor 102 of the second example, too, a portion of the ultrasonic sensor 102 is similarly assumed as a model. Fig. 15 illustrates the simulation results concerning the ultrasonic sensor 102. Regarding the ultrasonic sensor 103 of the third example, too, a portion of the ultrasonic sensor 103 is similarly assumed as a model.

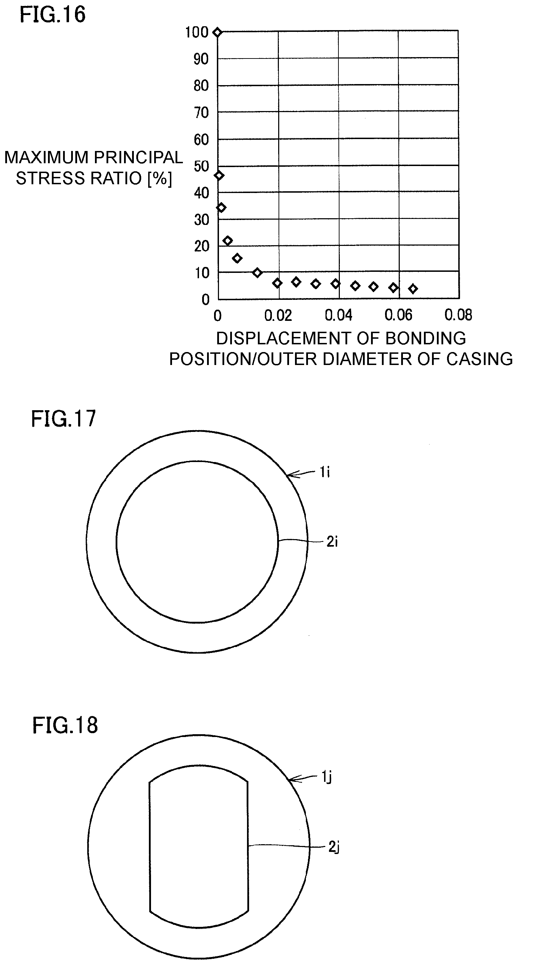

Fig. 16 illustrates the simulation results concerning the ultrasonic sensor 103. Regarding these models, too, increasing the displacement D of the bonding position can reduce the maximum principal stress ratio at the point B, as shown in Figs. 15 and 16.

### Shape of Hollow Portion

Variations of the shape of the hollow portion provided in the casing will be discussed. In Fig. 2, as the shape of the hollow portion 2 as viewed from above, a combination of two parallel straight lines and two semicircles is shown by way of example. However, the hollow portion as viewed from above is not limited to this shape and may be formed in another shape. For example, a casing 1i shown in Fig. 17 has a hollow portion 2i. The shape of the hollow portion 2i is a circle as viewed from above. The shape of the hollow portion 2i is concentric with respect to the outer shape of the casing 1i. The casing of the ultrasonic sensor may be configured in this manner.

A casing 1j shown in Fig. 18 has a hollow portion 2j. The hollow portion 2j has a shape of a combination of two straight lines and two arcs as viewed from above. The arcs are concentric with respect to the outer shape of the casing 1j. The casing of the ultrasonic sensor may be configured in this manner.

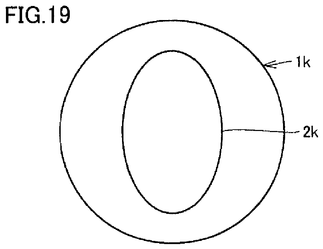

A casing 1k shown in Fig. 19 has a hollow portion 2k. The shape of the hollow portion 2k is an ellipse as viewed from above. The casing of the ultrasonic sensor may be configured in this manner.

Some examples of the shape of the hollow portion have been discussed above. However, the shape of the hollow portion as viewed from above is not limited to these examples and may be another shape. Regarding the casing, too, the shape of the casing as viewed from above is not restricted to a circle and may be another shape.

Among the above-described examples, some examples may be combined with each other.

The disclosed embodiments are provided only for the purposes of illustration, but are not intended to be exhaustive or to limit the invention to the precise forms disclosed. It is intended that the scope of the invention be defined by the following claims.

### Reference Signs List

1, 1c, 1d, 1e casing, 2 hollow portion, 5 first unit, 6, 6c, 6d, 6e second unit, 7 piezoelectric vibrator element, 8 terminal, 9 wiring, 11 lid, 12 filler, 13 bottom-plate first layer, 14 bottom-plate second layer, 16 surface, 61, 61c, 61d, 61e cylindrical section, 62, 62c, 62d, 62e bottom plate, 91 first direction, 101, 102, 103, 104 ultrasonic sensor

## Claims

1. An ultrasonic sensor (104) comprising:
a casing (1e); and
a piezoelectric vibrator element (7), wherein
the casing (1e) includes first (5) and second units (6e), , the first unit (5) being made of a metal, the second unit (6e) being made of a resin,
the first unit (5) is formed in a cylindrical shape extending in a first direction, and
the second unit (6e) is connected to one end of the first unit (5) in the first direction and includes a cylindrical section (61e) and a bottom plate (62e), the cylindrical section (61e) extending in the first direction, the bottom plate (62e) being a disk-like portion which closes an end of the cylindrical section (61e) positioned farther away from the first unit in the first direction, the piezoelectric vibrator element (7) being mounted on the bottom plate (62e),
**characterized in that**:
the bottom plate (62e) includes a bottom-plate first layer (13) and a bottom-plate second layer (14);
the bottom-plate first layer (13) is made of carbon fiber reinforced plastic, CFRP, and is positioned at a side of the bottom plate closer to the first unit (5) in the first direction; and
the bottom-plate second layer (14) is made of a resin different from CFRP and is positioned at a side of the bottom plate farther away from the first unit in the first direction.

2. The ultrasonic sensor according to claim 1, wherein the bottom-plate second layer (14) and the cylindrical section (61e) are integrally formed.

## Patentansprüche

1. Ultraschallsensor (104), der Folgendes aufweist:
ein Gehäuse (1e); und
ein piezoelektrisches Schwingerelement (7), wobei
das Gehäuse (1e) eine erste (5) und eine zweite (6e) Einheit umfasst, die erste Einheit (5) aus einem Metall hergestellt ist, die zweite Einheit (6e) aus einem Kunstharz hergestellt ist,
die erste Einheit (5) in einer zylindrischen Form ausgestaltet ist, die sich in einer ersten Richtung erstreckt, und
die zweite Einheit (6e) mit einem Ende der ersten Einheit (5) in der ersten Richtung verbunden ist und einen zylindrischen Abschnitt (61e) und eine Bodenplatte (62e) umfasst, der zylindrische Abschnitt (61e) sich in der ersten Richtung erstreckt, die Bodenplatte (62) ein scheibenähnlicher Teil ist, der ein Ende des zylindrischen Abschnitts (61e) verschließt, das in der ersten Richtung weiter von der ersten Einheit weg positioniert ist, das piezoelektrische Schwingerelement (7) an der Bodenplatte (62e) montiert ist,
**dadurch gekennzeichnet, dass**:
die Bodenplatte (62e) eine erste Bodenplattenschicht (13) und eine zweite Bodenplattenschicht (14) umfasst;
die erste Bodenplattenschicht (13) aus einem kohlenstofffaserverstärktem Kunststoff (Carbon Fiber Reinforced Plastic, CFRP) hergestellt ist und an einer Seite der Bodenplatte positioniert ist, die in der ersten Richtung näher an der ersten Einheit (5) ist; und
die zweite Bodenplattenschicht (14) aus einem von dem CFRP verschiedenen Kunstharz hergestellt ist und an einer Seite der Bodenplatte positioniert ist, die in der ersten Richtung weiter von der ersten Einheit weg ist.

2. Ultraschallsensor nach Anspruch 1, wobei die zweite Bodenplattenschicht (14) und der zylindrische Abschnitt (61e) einstückig ausgebildet sind.

## Revendications

1. Capteur à ultrasons (104) comprenant :
un boîtier (1e) ; et
un élément vibrateur piézoélectrique (7), dans lequel
le boîtier (1e) comprend une première (5) et une deuxième (6e) unité,
la première unité (5) étant faite d'un métal, la deuxième unité (6e) étant faite d'une résine,
la première unité (5) est formée en une forme cylindrique s'étendant dans une première direction, et la deuxième unité (6e) est connectée à une extrémité de la première unité (5) dans la première direction et comprend une section cylindrique (61e) et une plaque de fond (62e), la section cylindrique (61e) s'étendant dans la première direction, la plaque de fond (62e) étant une partie semblable à un disque qui ferme une extrémité de la section cylindrique (61e) positionnée plus loin de la première unité dans la première direction, l'élément vibrateur piézoélectrique (7) étant monté sur la plaque de fond (62e), **caractérisé en ce que** :
la plaque de fond (62e) comprend une première couche (13) de plaque de fond et une deuxième couche (14) de plaque de fond ;
la première couche (13) de plaque de fond est faite de plastique renforcé de fibres de carbone, CFRP, et est positionnée à un côté de la plaque de fond plus près de la première unité (5) dans la première direction ; et
la deuxième couche (14) de plaque de fond est faite d'une résine différente de la CFRP et est positionnée à un côté de la plaque de fond plus loin de la première unité dans la première direction.

2. Capteur à ultrasons selon la revendication 1, dans lequel la deuxième couche (14) de plaque de fond et la section cylindrique (61e) sont formées intégralement.
